# EUROPEAN PATENT APPLICATION

(11) **EP 1 873 279 A1**
(43) Date of publication of application: **02.01.2008**
(21) Application number: 06116370.5
(22) Date of filing: 30.06.2006
(51) Int. Cl.: C30B 7/00, C30B 29/06, C01G 9/02

(54) **Nanorod, method for its manufacture, nano contact, nano electric device, and bath for growing a nanorod.**

(71) Applicant: Stormled AB, 412 96 Goteborg (SE)
(72) Inventor: Hu, Qiu-Hong, 413 14, GÖTEBORG (SE); Willander, Magnus, 582 28, LINKÖPING (SE)
(74) Representative: Edlund, Fabian

(57) **Abstract**

A nano rod (1) comprising an oblong Zinc oxide nano construct, wherein the oblong Zinc oxide nano construct (3) is, as grown, free standing. A nano contact and a nano electric device are also disclosed. Also, a method for manufacturing a nano rod at low temperatures is also disclosed. A bath for growing nano rods is also disclosed.

## Description

### TECHNICAL FIELD

According to a first aspect, the present invention relates to a nanorod.

According to a second aspect, the present invention relates to a nano contact.

According to a third aspect, the present invention relates to a nano electric device.

According to a fourth aspect, the present invention relates to a method for manufacturing a nanorod.

According to a fifth aspect, the present invention relates to a bath for growing a nanorod.

### BACKGROUND OF INVENTION

ZnO with the band gap of 3.37 eV at room temperature and the exciton binding energy of 60 meV, rich variety of nanostructures, and inexpensiveness have attracted a great attention as a potential commercially viable candidate for ultraviolet light emitters ushering applications in laser diodes, high brightness light emitting diodes in ultraviolet and visible ranges. The demonstration of optical lasing at room temperature from ZnO nanowires unveiled the great potential in fabricating very high efficiency light emitters, and escalated the research on finding and utilizing cost effective and up-scalable production methods for the growth of ZnO nanowires.

Apart from physical methods such as molecular beam epitaxi, pulsed laser ablation, various chemical methods have also been developed, among others, the catalytic vapour-liquid-solid growth, which allows the growth of the nanowires at temperatures between 800-900°C, thermal decomposition of Zn3N2 or of ZnCl2 and oxidation between 300-600°C. The ZnO nanowires have been grown on various kinds of substrates, Si, SiC, GaAs, and Sapphire. Today nanowires are thus grown in high temperature which is both laborious and expensive, e.g. since there is a risk of contaminating of the nanowire, e.g. during the heating by diffusion.

A particularly interesting development is the so-called low temperature growth, where the growth takes place at about 95°C in aqueous solution. This method involves two processes, a homogeneous or heterogeneous nucleation of ZnO, and a subsequent growth of the nanowires. The sites for homogeneous nucleation or the seed layer are created by depositing Zn-containing precursors on a substrate and oxidizing it. The quality of the nucleation sites in terms of density, uniformity and the strength of adhesion to the substrate rely heavily on the completeness of the oxidation. Depending on the precursors chosen and its thickness, the temperature required for the oxidation can be as high as 420°C (X. Feng et al., J. Am. Chem. Soc. 2004, 126, 63 (2004). Such a high temperature excludes the possibility of growing ZnO nanowires on substrates like plastics, or other temperature sensitive materials.

It is of great societal value, perhaps especially in the information display and lighting industry, to be able manufacture nanorods at low temperature and to be able to offer nanorods presenting intact structural and physical properties.

### SUMMARY OF THE INVENTION

In this document the terms nanowire, a nanopillar, nanorod, a nanowhisker, may be understood interchangeably. Also the close connection to nanonetworks, i.e. a network of nanorods, should be acknowledged.

According to the first aspect, a nanorod comprising an oblong zinc oxide nano construct is disclosed.

The oblong zinc oxide nano construct is, as grown, freestanding. This offers the advantage of freestanding nanorods that do not need post processing since post processing may damage the rods. Thus the nanorod according to the first aspect presents improved physical properties thanks to them being structurally intact.

In an embodiment, the nano construct further comprises an end presenting an electrically conductive layer.

In an embodiment, the electrically conductive layer is essentially flat. This leads to increased opportunities to control the physical properties, including electrical properties, such as conductivity, and reflectivity and transparency. Also, it is easier to have control over the thickness, and its physical consequences, when the layer is flat.

In an embodiment, the electrically conductive layer is a nucleation layer.

In an embodiment, the electrically conductive layer belongs to the group of a metallic layer, an electrically conductive ceramic layer, and a transparent conductive oxide layer.

In an embodiment, the metallic layer belongs to the groups of a layer of a transition metal, a layer of a noble metal, a layer of a metal, and a layer of a metal alloy.

In an embodiment, the layer of a noble metal is constituted by one from the group of Gold (Au), Platinum (Pt), Silver (Ag), Cupper (Cu), Palladium (Pd), and Tantalum. In general, noble metals may also be referred to as coin metals and precious metals. The term noble metal includes metals that that resist chemical action, does not corrode or tarnish on air or water, and is not easily attacked by acids.

In an embodiment, the transparent conductive oxide layer is an Indium Tin oxide (ITO) layer.

In an embodiment, the nominal thickness of the electrically conductive layer is between 1 and 3 nanometers. Nominal thickness may be as read from QCM (Quartz Crystal Microbalance).

In an embodiment, the nominal thickness of the electrically conductive layer is more than 0.5 nanometers.

The nanorod according to the first aspect may be seen as a free standing rod, i.e. it is not associated with a substrate that it may have grown upon.

According to the second aspect, a nano contact is disclosed. The nano contact comprises two contact pads of opposite polarity and nanorods according to the first aspect are electrically connected to the two contact pads. This offers the advantage that the electrically conductive layer will serve as one of the contacts. This is a consequence of the low temperature manufacturing process, which will be discussed below.

In an embodiment, the electrically conductive layer presents a nominal thickness between 2 and 200 nanometers.

In an embodiment, the electrically conductive layer presents a nominal thickness between 5 and 200 nanometers.

In an embodiment, the nano contact is of one of a Schottky contact and an Ohmic contact.

In an embodiment, one of the contact pads is constituted by single walled carbon nanotubes (SWCNT).

According to the third aspect, a nano electric device comprising a substrate at a surface of which a plurality of nanorods according to the first aspect is disclosed. The plurality of nanorods are electrically connected to the surface.

In an embodiment, the substrate, or a part thereof, is constituted by one of the group of glass, conductive plastic, conductive polymer, Silicon (Si), Silicon Carbide (SiC), Sapphire (Al₂O₃), Silicon Nitride, Poly(3,4-ethylene-dioxythiophene) (PEDOT), transparent conductive oxide family (TCO) such as p-SrCu₂O₂. That is, not only materials that may accept only high temperatures but also materials that do not accept high temperature are included in this embodiment.

According to the fourth aspect, a method for manufacturing a nanorod is disclosed. The method comprises
- providing an assembly by providing an electrically conductive layer on a surface of a substrate,
- heat treating the assembly in a mixture of zinc containing precursor (usually in the form of zinc salt) and tetramine in water, and
- drying the assembly.

An advantage is that the present invention makes it is possible to perform the method in a low temperature environment, i.e. the nanorod does not have to be heated to as a high temperature as before. This leads to that the nanorod, including the electrically conductive layer, presents essentially the same structural, chemical and physical properties as an electrically conductive layer that has not been subjected to the method according to the fourth aspect. Thus, it is intact.

In an embodiment, the step of providing comprises covering all surfaces of the substrate with the electrically conductive layer.

In an embodiment, the providing of the electrically conductive layer is achieved by heterogeneous nucleation.

In an embodiment, the providing of the electrically conductive layer is achieved by dispersing colloidal particles related to the electrically conductive layer on the surface of the substrate.

In an embodiment, the providing of an electrically conductive layer results in presenting a nominal thickness of the electrically conductive layer being more than 0.5 nanometers.

In an embodiment, the heat treating is done in a temperature interval of 30 and 120 degrees Celsius.

In an embodiment, the heat treating is done in a temperature interval of 50 to 95 degrees Celsius.

In an embodiment, the method further comprises adding at least one additional precursor, e.g. a band-gap modifier or a dopant, to the mixture.

In an embodiment, the adding at least one additional precursor comprises adding a salt comprising at least of Mg²⁺ and Cd²⁺ to the mixture.

In an embodiment, the adding at least one precursor comprises adding at least one dopant substance to the mixture.

In an embodiment, the relation between precursor, e.g. a zinc containing precursor, or even more specifically Zn(NO₃)₂ and the band gap modifier is 67%-99%:33-1%.

In an embodiment, the method further comprises controlling at least one of:
- size of at least one region of electrically conductive layer on the substrate, and
- position on the substrate.

In the art, this is referred to as lithographic (pre)patterning.

In an embodiment, the method at least one of the following methods is: photolithography and e-beam lithography. E-beam lithography allows for a higher resolution and thus a better accuracy when providing of the pattern on the substrate.

Controlling the size of position of nucleation layer for heterogeneous nucleation allows us to control the position and diameter of subsequent growing nanorod. This can be done by periodic patterning of the substrate with the help of photolithography. This allows us to control the spacing and diameter of the metal spots for nucleation that gives the possibility to control the spacing between the nanorods, and the diameter of nanorods. Since this process defines the exact nucleation area, it allows us to control and influence the active p-n junction area. This feature can give further insight into the problem of heat management and junction area, junction current density etc. Controlling these parameters is crucial for standardizing the LED-product at a later stage of technical development. These are part of standard product management and product development in the LED industry. For special applications where the resolution of photolithography is not sufficient, e-beam lithography could be employed, giving higher precision.

According to the fifth aspect, a bath for growing a nanorod on an electrically conductive layer is disclosed. It comprises a zinc containing precursor, e.g. Zn(NO₃)₂, tetramine, e.g. hexa methyl tetramine, and at least one additional precursor. Thus the bath is a wet chemical bath.

In an embodiment, the at least one additional precursor is a salt comprising at least of Mg²⁺ and Cd²⁺.

In an embodiment, the at least one additional precursor is a dopant substance.

In an embodiment, the relation between zinc containing precursor, e.g. Zn(NO₃)₂ and the at least one additional precursor is 67-1%:33-1%.

In an embodiment, the nanorod is a nanorod according to the first aspect.

### BRIEF DESCRIPTIONS OF DRAWINGS

In Figure 1A, an embodiment of a nanorod is given.

In Figure 1B, an embodiment of a nanorod from a side view that comprises an end presenting an electrically conductive layer is given.

In Figures 2A and 2B, embodiments of nano contacts are given.

In Figure 3, an embodiment of a nano electric device is given.

### PREFERRED EMBODIMENTS OF THE INVENTION

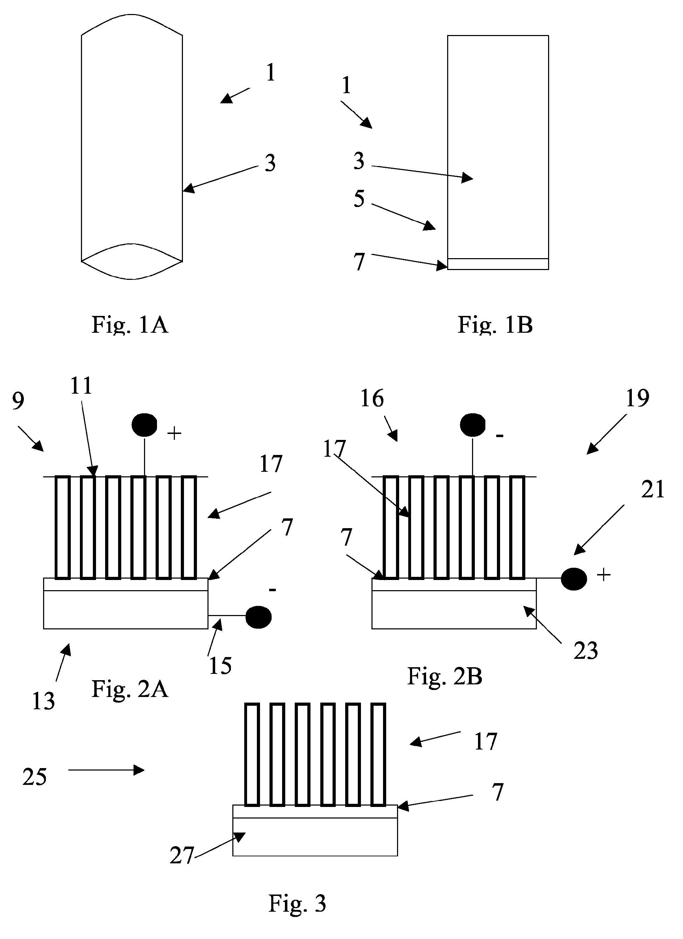

In Figure 1A, an embodiment of a free standing nano rod 1 is given. The nanorod 1 comprises an oblong Zinc oxide nano construct 3 and the oblong Zinc oxide nano construct 3 is, as grown, free standing.

In another embodiment shown in Figure 2, a free standing nanorod 1 comprises an end 5 presenting an electrically conductive layer 7. The electrically conductive layer 7 is essentially flat.

In an embodiment, the electrically conductive layer 7 is a nucleation layer. A thin metal layer is deposited typically with methods such as sputtering or e-beam evaporation. Typically this layer presents a nominal thickness between 1 and 3 nanometers. In this embodiment, the electrically conductive layer 7 belongs to a metallic layer, namely a layer of Gold (Au) and other metals. In an alternative embodiment, the nominal thickness of the electrically conductive layer 7 is more than 0.5 nanometers.

The free standing nanorods 1, as described above, may be manufactured according to the following steps.
- Heat treating a mixture of Zn(NO₃)₂ and hexa methyl tetramine in water according to temperature and time as indicated below , and
- Drying the assembly.

Alternatives to electrically conductive layers 7 include TCO, ITO and single walled carbon nanotubes (SWCNT). ITO - In₂O₃ doped with SnO₂ (Indium Tin Oxide, usually combined by weight in 90%:10% ratio) is a preferred alternative to the electrically conductive nucleation layer. It provides a nano contact due to its high conductivity and good transparency at thicknesses up to 200nm. The properties of ITO are high conductivity combined with high transparency in the visible region that is useful in numerous applications. In alternative embodiments, there are other alternatives to ITO that may be selected from the group of TCOs (transparent conductive oxides), for instance Al or Ga doped ZnO (AZO and GZO). These may offer properties such as lower resistivity, higher stability and better transparency than ITO. Another group of materials that can be used for such an electrode are single walled nanotubes (SWCNT). SWCNT can be used as transparent conductive electrodes with superior properties than ITO, with regards to the transparency and conductivity. These electrodes are low cost in production as they do not require standard high vacuum technologies employed for ITO deposition, such as e-beam evaporation or sputtering. This eliminates an expensive step in the production process. SWNT can be purchased in a solution and can be deposited onto the wafer by regular spin-coating or dip-coating. The work function of SWNT has been reported to be in the range of 4.5 to 5 eV, which is well-suited for making a nano contact to ZnO nanowires.

In Figure 2A an embodiment of a nano contact 9 is given. The nano contact 9 comprises two contact pads 11, 13 of opposite polarity (a top contact and a bottom contact), a substrate 15 and nano rods 17 electrically connecting the two contact pads 9, 11. The substrate 15 constitutes the bottom contact.

In Figure 2B, an embodiment of a nano contact 16 is given. The nano contact 16 comprises two contact pads 19, 21 of opposite polarity (a top contact and a bottom contact), a substrate 23 and nano rods 17 electrically connecting the two contact pads 19, 21. The substrate 23 is an isolating substrate 23. The electrically conductive layer 7 presents a nominal thickness between 2 and 200 nanometers. The work function of the electrically conductive layer 7 should be considered with respect to the decreasing the Schottky barrier between the metal and semiconductor in order to give a good ohmic contact. Even alloys of different metals can be used in this case. The case with work function alignment is different depending if ZnO nanowires grown are going to be p- or n-type. The thickness of the electrically conductive layer will have an effect on transparency of the device.

In Figure 3, an embodiment of a nano electric device 25 is given. It comprises a substrate 27 at a surface of which a plurality of nanorods 17 has been grown. The substrate 27 is constituted by a conductive plastic.

In an embodiment, the method for manufacturing a nanorod according to the present invention comprises 1) providing an assembly by providing an electrically conductive layer on a surface of a substrate, 2) heat treating the assembly in a mixture of Zn(NO₃)₂ and hexa methyl tetramine in water, and 3)drying the assembly. The temperature for the process lies in the interval of 30 and 120 degrees Celsius. The time needed in the heat treating step lies in the interval 30 minutes to 3 hours. A longer time leads to longer rods and thicker rods.

Typical dimensions, such as length, of nanorods developed with the low temperature growth according to the present invention are dependent on growth time. The experimental approximate growth time is one micrometer per hour. For further LED-fabrication reasons, nanorods of the order of approximately one micrometer in length are optimal. The diameters of nanorods that have been achieved are typically 100 nanometers. Larger diameters such as 500 to 1000 nanometers together with narrow spacing between the nanowires that gives the advantage of covering a larger portion surface area. However producing a critically small diameter gives the advantage of quantum confinement and light extraction. Using the inventive method it is possible to obtain an aspect ratio as low as 1.

Also, it is possible to insert metals and materials to modify the band-gap. MgₓZn₁₋ₓO and Zn_{y}Cd_{1-y}O can be formed by adding salts to the solution containing Mg²⁺ and Cd²⁺ ions together with Zn containing salt into the growth solution. In the resulting growth, Mg²⁺ or Cd²⁺ ions are incorporated into the crystal lattice structures in Zn place. The band gap and lattice constant may be changed linearly depending on the composition of the alloy. The band-gap can thus be tuned engineered between 3.0 (y=0.07) and 4.0 eV (x=0.33).

When having provided the substrate with an effective nucleation layer, the growth of alloys takes place by introducing different compositions of Zn containing salts together with either Mg or Cd salts. In an embodiment, the inventive method could include a timed, periodic variance of concentration of precursors (Zn, Cd and Mg) in the wet chemical solution providing growth of different compositions of alloys and ultimately confinement characteristics of the semiconductor structure.

A sample of growing Cd_{y}Zn_{1-y}O structure could be growth of an alloy with a smaller band-gap, on a p-type substrate with a larger bad-gap that that of the alloy, providing an enhanced hole injection from the p-type layer into the alloy.

In an embodiment, a highly efficient light emitting device is based on MgₓZn₁₋ₓO (that has the band-gap energy between 3.37 and 4.02 at room temperature) alloy in the form of nanorods. MgₓZn₁₋ₓO may appropriately be used in the cladding layers between which the active layer is sandwiched. The active layer can consist of a multiple of quantum wells or a double heterostructure. The active region may contain any alloy composition of either MgₓZn₁₋ₓO, ZnO or CdₓZn₁₋ₓO with a smaller band-gap energy than then cladding layer, providing enhanced light emission characteristic and carrier confinement within the active layer. The nanorods containing these alloys are grown with by the in the wet chemical bath.

In an alternative embodiment, dopants are included in of the growth process. By introducing foreign dopant substances during the growth process, it is possible to modify the electronic properties of ZnO nanorods or parts thereof. Depending on the substance introduced, the effect can be either the increase in n-type carriers or an overcompensation of n-type conductivity that will result in p-type doping (by foreign atoms being incorporated into ZnO structure)

As grown ZnO is a natural n-type semiconductor with doping level of the order of 10¹⁷ to 10¹⁸ n-type carriers/cm³. However, larger doping concentration and conduction may be desired. An increase in n-type doping can be attained by adding group III elements that will substitute Zn positions, Al, Ga and In. For compensating n-type conductivity and attaining p-type any element or combination of elements of Li, Na, Cu, P As could be used (group I will substitute Zn positions and group III will substitute O positions). Cu can function as a p-type dopant due to formation of CuO that is a p-type semiconductor in the non-doped status. Al, Ga and In, co-doped with N could also result as a source of p-type conductivity.

Regarding the bath, the molar relation between the Zinc containing precursor and tetramine should be approximately 1:1 and the molar relation between the at least one additional doping precursor, and the Zinc containing precursor and the tetramine, should be lower than approximately 10%, i.e. 0.9:0.1:1 (for carrier concentration), and 0.67:0.33:1 (for band gap modification).

Non-limiting application areas of the present invention include LED, LD (laser diode), solar cells, transistors etc. The ZnO nanorods could also be utilised as transparent electrodes. Single nanorods grown between two contact pads could also be utilised in a number of future sensitive nanotechnology applications.

## Claims

1. Nanorod (1) comprising an oblong Zinc oxide nano construct (3), wherein the oblong Zinc oxide nano construct (3) is, as grown, freestanding.

2. Nanorod according to claim 1, wherein the nano construct (3) further comprises an end (5) presenting an electrically conductive layer (7).

3. Nanorod according to claim 1, wherein the electrically conductive layer (7) is essentially flat.

4. Nanorod according to claim 1, wherein the electrically conductive layer (7) is a nucleation layer.

5. Nanorod according to claim 1, wherein the electrically conductive layer (7) belongs to the group of a metallic layer, an electrically conductive ceramic layer, and a transparent conductive oxide layer.

6. Nanorod according to claim 5, wherein the metallic layer belongs to the groups of a layer of a transition metal, a layer of a noble metal, a layer of a metal, and a layer of a metal alloy.

7. Nanorod according to claim 6, wherein the layer of a noble metal is constituted by one from the group of Gold (Au), Platinum (Pt), Silver (Ag), Cupper (Cu), Palladium (Pd), and Tantalum.

8. Nanorod according to claim 5, wherein the transparent conductive oxide layer is an Indium Tin oxide (ITO) layer.

9. Nanorod according to claim 1, wherein the nominal thickness of the electrically conductive layer (7) is between 1 and 3 nanometers.

10. Nanorod according to claim 1, wherein the nominal thickness of the electrically conductive layer (7) is more than 0.5 nanometers.

11. Nano contact (9, 17) comprising two contact pads (11, 13; 19, 21) of opposite polarity and nanorods (17) according to any one of claims 1 to 10 electrically connecting the two contact pads (11, 13; 19, 21).

12. Nano contact according to claim 11, wherein the electrically conductive layer (7) presents a nominal thickness between 2 and 200 nanometers.

13. Nano contact according to claim 11, wherein the electrically conductive layer (7) presents a nominal thickness between 5 and 200 nanometers.

14. Nano contact according to claim 12, wherein the nano contact is of one of a Schottky contact and an Ohmic contact.

15. Nano contact according to claim 11, wherein one of the contact pads (11, 13; 19, 21) is constituted by a single wall carbon nanotube (SWCNT).

16. Nano electric device (25) comprising a substrate (27) at a surface of which a plurality of nanorods (1) according to any one of claims 2 to 10 are electrically connected.

17. Nano electric device according to claim 16, wherein the substrate (27), or a part thereof, is constituted by one of the group of glass, conductive plastic, conductive polymer, Silicon (Si), Silicon Carbide (SiC), Sapphire (Al₂O₃), Silicon nitride, Poly(3,4-ethylene-dioxythiophene) (PEDOT), and p-SrCu₂O₂.

18. Method for manufacturing a nanorod (17), comprising:
- providing an assembly by providing an electrically conductive layer (7) on a surface of a substrate (15, 23, 27),
- heat treating the assembly in a mixture of a Zinc containing precursor and tetramine in water, and
- drying the assembly.

19. Method according to claim 18, wherein the step of providing comprises covering all surfaces of the substrate with the electrically conductive layer (7).

20. Method according to claim 18, wherein the providing of the electrically conductive layer (7) is achieved by heterogeneous nucleation.

21. Method according to claim 18, wherein the providing of the electrically conductive layer (7) is achieved by dispersing colloidal particles related to the electrically conductive layer (7) on the surface of the substrate (15, 23, 27).

22. Method according to claim 18, wherein the providing of an electrically conductive layer (7) results in presenting a nominal thickness of the electrically conductive layer (7) being more than 0.5 nanometers.

23. Method according to claim 18, wherein the heat treating is done in a temperature interval of 30 and 120 degrees Celsius.

24. Method according to claim 18, wherein the heat treating is done in a temperature interval of 50 to 95 degrees Celsius.

25. Method according to claim 18, further comprising adding at least one precursor to the mixture.

26. Method according to claim 18, wherein the adding at least one precursor comprises adding a salt comprising at least of Mg²⁺ and Cd²⁺ to the mixture.

27. Method according to claim 18, wherein the at least one additional precursor comprises adding at least one dopant substance to the mixture.

28. Method according to claim 25, wherein the relation between the precursor and the at least one additional precursor is 67-99%:33-1%.

29. Method according to claim 18, further comprising controlling at least one of:
- size (and pattern) of at least one region of electrically conductive layer (7) on the substrate, and
- position on the substrate.

30. Bath for growing a nanorod on an electrically conductive layer (7), comprising a zinc containing precursor, tetramine, and at least one additional precursor.

31. Bath according to claim 30, wherein the at least one additional precursor is a salt comprising at least of Mg²⁺ and Cd²⁺.

32. Bath according to claim 30, wherein the at least one additional precursor is a dopant substance.

33. Bath according to claim 30, wherein the relation between Zinc containing precursor and the at least one additional precursor is 67-99%:33-1%.

34. Bath according to claim 30, wherein the nanorod is a nanorod according to any one of claims 1 to 10.
